# EUROPÄISCHE PATENTSCHRIFT

(11) **EP 4 031 886 B1**
(45) Veröffentlichungstag und Bekanntmachung des Hinweises auf die Patenterteilung: **05.08.2026**
(21) Anmeldenummer: 20780913.8
(22) Anmeldetag: 21.09.2020
(51) Int. Cl.: G01R 31/367, G01R 31/392, G01R 31/396, B60L 58/16

(54) **ZUSTANDSWERT FÜR WIEDERAUFLADBARE BATTERIEN**
CONDITION VALUE FOR RECHARGEABLE BATTERIES
VALEUR D'ÉTAT POUR BATTERIES RECHARGEABLES

(30) Priorität: 20.09.2019 DE 102019125375
(43) Veröffentlichungstag der Anmeldung: 27.07.2022
(73) Patentinhaber: TWAICE Technologies GmbH, 80807 München (DE)
(72) Erfinder: BAUMANN, Michael, 80805 München (DE)
(74) Vertreter: Kraus & Lederer PartGmbB
(86) Internationale Anmeldenummer: PCT/DE2020/100813
(87) Internationale Veröffentlichungsnummer: WO 2021/052540

(56) Entgegenhaltungen:
- WO-A1-2015/197483
- WO-A1-2020/224724
- DE-A1- 102016 202 572
- DE-A1- 102017 103 348
- US-A1- 2013 231 826

## Beschreibung

### TECHNISCHES GEBIET

Verschiedene Beispiele der Erfindung betreffen im Allgemeinen Techniken zur Charakterisierung einer Batterie. Insbesondere betreffen verschiedene Beispiele der Erfindung Techniken, um einen Zustandswert im Zusammenhang mit einer Alterung einer wiederaufladbaren Batterie zu bestimmen.

### HINTERGRUND

Wiederaufladbare Batterien, beispielsweise Traktions-Batterien von Elektrofahrzeugen, weisen eine begrenzte Lebensdauer auf. Zum Beispiel kann der sogenannte Gesundheitszustand (engl. state of health, SOH) von Batterien über der Zeit abnehmen, beispielsweise als Funktion von Ladezyklen. Dies kann zum Beispiel im Zusammenhang mit dem zuverlässigen Betrieb eines entsprechenden Batteriegetriebenen Geräts problematisch sein. Der SOH ist typischerweise im Zusammenhang mit Kapazität und Impedanz einer Batterie bestimmt.

Es wurde beobachtet, dass es manchmal nur eingeschränkt möglich ist, den tatsächlichen Zustand einer wiederaufladbaren Batterie auf Grundlage des SOH allein zu bestimmen.

WO 2015/197483 A1 betrifft eine Vorrichtung zur Regelung eines Ladezustands eines elektrischen Energiespeichers.

### KURZE BESCHREIBUNG DER ERFINDUNG

Deshalb besteht ein Bedarf für verbesserte Techniken zur Charakterisierung von wiederaufladbaren Batterien.

Diese Aufgabe wird gelöst von den Merkmalen der unabhängigen Patentansprüche. Die Merkmale der abhängigen Patentansprüche definieren Ausführungsformen.

Ein Verfahren zum Ermitteln eines Zustandswerts im Zusammenhang mit einer Alterung einer wiederaufladbaren Batterie umfasst das Ermitteln eines gegenwärtigen Alterungswerts der Batterie. Das Verfahren umfasst außerdem das Ermitteln eines zukünftigen Alterungswerts der Batterie. Dazu wird ein Alterungsmodell verwendet. Das Ermitteln des zukünftigen Alterungswerts berücksichtigt auch den gegenwärtigen Alterungswert der Batterie. Außerdem umfasst das Verfahren das Ermitteln des Zustandswerts der Batterie, basierend auf mehreren Alterungskenngrößen. Die mehreren Alterungskenngrößen umfassen zum Beispiel den gegenwärtigen Alterungswert und/oder den zukünftigen Alterungswert.

Beispielsweise kann der gegenwärtige Alterungswert der SOH der Batterie sein oder diesen umfassen. Der gegenwärtige Alterungswert könnte ein oder mehrere Leistungskenngrößen der Batterie umfassen, also z.B. Kapazität oder Impedanz, usw. Der SOH kann zum Beispiel die Kapazität oder die Impedanz der Batterie beschreiben. Beispielsweise könnte der SOH indikativ für eine Abnahme der maximalen Kapazität gegenüber dem ursprünglichen Zustand sein.

Indem neben dem gegenwärtigen Alterungswert der Batterie auch der zukünftige Alterungswert der Batterie beim Ermitteln des Zustandswerts der Batterie berücksichtigt wird, kann eine zuverlässige und umfassende Aussage über den tatsächlichen Zustand der Batterie getroffen werden. Es ist nämlich manchmal der Fall, dass eine baldige signifikante Abnahme etwa des SOH aus dem gegenwärtigen Alterungswert alleine nicht oder nicht zuverlässig ersichtlich ist. Beispielsweise wurden Situationen beobachtet, bei denen der SOH der Batterie sprunghaft abnimmt. Dann kann der gegenwärtige Alterungswert kurz vor einer solchen sprunghaften Abnahme liegen: der Zustand der Batterie ist demnach kritisch, was jedoch anhand des gegenwärtigen Alterungswerts alleine nicht ersichtlich sein kann.

Als allgemeine Regel können unterschiedliche Implementierungen für den zukünftigen Alterungswert der Batterie verwendet werden. Der zukünftige Alterungswert kann eine oder mehrere Leistungskenngrößen der Batterie umfassen. Der zukünftige Alterungswert könnte z.B. den SOH der Batterie für einen oder mehrere zukünftige Zeitpunkte beschreiben. Beispielsweise wäre es denkbar, dass der zukünftige Alterungswert eine kalendarische Wertereihe ein oder mehrerer Leistungskenngrößen der Batterie umfasst. Die kalendarische Wertereihe kann also die ein oder mehreren Leistungskenngrößen als Funktion der Betriebszeit und/oder der Ladezeit spezifizieren. Alternativ oder zusätzlich wäre es aber auch denkbar, dass der zukünftige Alterungswert eine zyklisierte Wertereihe der ein oder mehreren Leistungskenngrößen der Batterie umfasst. Eine solche zyklisierte Wertereihe entspricht einer Spezifikation der ein oder mehreren Leistungskenngrößen als Funktion von Ladungs- und Entladungszyklen der Batterie.

Es wäre zum Beispiel möglich, dass das Verfahren weiterhin umfasst: Bestimmen eines Abstands zu einem Lebensende-Kriterium der Batterie. Der Abstand kann zum Beispiel wiederum kalendarisch und/oder zyklisiert ausgedrückt sein, das heißt zum Beispiel in Betriebsstunden und/oder Ladungszyklen. Eine solche Bestimmung des Abstands zum Lebensende-Kriterium kann auf einer Analyse der Wertereihe basieren. Derart kann nämlich eine Signatur der ein oder mehreren Leistungskenngrößen der Batterie in der Wertereihe erkannt werden, welche dem Lebensende-Kriterium entspricht. Beispielsweise könnte die Signatur eine sprunghafte Abnahme der ein oder mehreren Leistungskenngrößen umfassen. Ein solches "Abknicken" einer Leistungskenngröße der Batterie (etwa eine plötzliche Abnahme der Kapazität) kann indikativ für eine plötzliche Verschlechterung des Zustandswerts der Batterie sein. Ein solches "Abknicken" kann einer nichtlinearen Degradierung der Batterie entsprechen. In dem solche nichtlinearen Effekte im Zusammenhang mit dem Zustandswert und insbesondere zum Beispiel im Zusammenhang mit der prospektiven Vorhersage der Alterung berücksichtigt werden, kann der Zustand der Batterie besonders zuverlässig abgeschätzt werden, insbesondere in Anbetracht möglicher unterschiedlicher Anwendungsszenarien.

Es wäre dann möglich, dass die mehreren Alterungskenngrößen, die beim Ermitteln des Zustandswerts der Batterie berücksichtigt werden, diesen Abstand zum Lebensende-Kriterium umfassen.

Dabei sind aber auch andere Lebensende-Kriterien denkbar. Es wäre beispielsweise möglich, dass die entsprechende Signatur eine Abnahme mindestens einer der ein oder mehreren Leistungskenngrößen unter einen Schwellenwert umfasst. je nach Leistungskenngröße, könnte auch die Überschreitung eines Schwellenwerts als Signatur verwandten werden. Z.B. könnte die Kapazität unter einen Schwellenwert fallen; und die Impedanz über einen Schwellenwert steigen.

Als allgemeine Regel wären verschiedene Techniken denkbar, um den Schwellenwert zu bestimmen. Beispielsweise könnte der Schwellenwert fest vorgegeben sein. Der Schwellenwert könnte aber auch dynamisch bestimmt werden. Zum Beispiel könnte der Schwellenwert im Rahmen des Verfahrens in Abhängigkeit von einem antizipierten Belastungsprofil der Batterie bestimmt werden. Dies bedeutet, dass für unterschiedliche Belastungsprofile der Batterie unterschiedliche Schwellenwerte verwendet werden könnten. Dies hat den Hintergrund, dass unterschiedliche Belastungsprofile oftmals mit unterschiedlichen Anwendungsszenarien assoziiert sind. Dementsprechend kann es im Zusammenhang mit dem Schwellenwert denkbar sein, dass für unterschiedliche Anwendungsszenarien unterschiedliche Abnahmen der ein oder mehreren Leistungskenngrößen der Batterie akzeptabel sind, ohne einen Betrieb, der durch die Batterie mit Energie versorgt wird, zu stören. Außerdem kann bei zum Beispiel konservativeren antizipierten Belastungsprofilen der Batterie (d.h. zum Beispiel weniger Leistungsentnahme pro Zeiteinheit, geringere Tiefenentladung, begrenzte maximale Ladung, etc.) eine stärkere Abnahme der ein oder mehreren Leistungskenngrößen tolerierbar sein; und somit kann ein niedrigerer Schwellenwert gewählt werden.

Als allgemeine Regel wäre es in den verschiedenen hierin beschriebenen Beispielen denkbar, dass ein Belastungsprofil (etwa ein antizipiertes oder auch ein historisches Belastungsprofil) einer Batterie als kalendarische und/oder zyklisierte Wertereihe ein oder mehrerer Leistungskenngrößen der Batterie ausgedrückt wird. Alternativ oder zusätzlich wäre es aber auch möglich, dass ein Belastungsprofil Ereignis-bezogen implementiert wird; das heißt ein oder mehrere Ereignisse indiziert, bei denen ein oder mehrere Leistungskenngrößen in mindestens einem vorgegebenen Bereich liegen. Ein solcher vorgegebener Bereich kann einer besonders großen, Ereignis-bezogenen Belastung der Batterie entsprechen. So wäre es zum Beispiel denkbar, dass der mindestens eine vorgegebene Bereich mit einer irreversiblen Lithium-Ablagerung an einer Elektrode der Batterie assoziiert ist (engl. lithium-plating).

Es sind unterschiedliche Techniken denkbar, um das antizipierte Belastungsprofil zu ermitteln. In einem Beispiel könnte das antizipierte Belastungsprofil basierend auf der bisherigen Belastung, d.h. einem historischen Belastungsprofil, bestimmt werden. Das antizipierte Belastungsprofil könnte aber auch in Abhängigkeit von einem zukünftigen Anwendungsszenario der Batterie bestimmt werden.

Das Alterungsmodell ermittelt mehrere zukünftige Alterungswerte basierend auf mehreren antizipierten Belastungsprofilen.

Dabei entsprechen die mehreren antizipierten Belastungsprofile mehreren Anwendungsszenarien.

Dann könnte der Zustandswert beispielsweise unter Berücksichtigung der mehreren antizipierten Alterungswerte bestimmt werden, für die verschiedenen Belastungsprofile. Es wäre beispielsweise möglich, die mehreren antizipierten Alterungswerte miteinander zu vergleichen. Beispielsweise könnte eine Varianz der antizipierten Alterungswerte bestimmt werden. Damit könnte z.B. eine Worst-Case-Abschätzung ermöglicht werden. Beispielsweise könnte der Worst-Case-Fall besonders stark bei der Ermittlung des Zustandswerts berücksichtigt werden.

Die mehreren antizipierten Belastungsprofile und die damit zusammengehörigen mehreren zukünftigen Alterungswerte werden auch verschiedenen Anwendungsszenarien zugeordnet. Manche Anwendungsszenarien - und die damit verknüpften antizipierten Belastungsprofile - können eine geringere Belastung oder eine anders gelagerte Belastung (d.h. zum Beispiel Betrieb der Batterie in anderen Betriebsbereichen der entsprechenden ein oder mehreren Leistungskenngröße, bei tieferen Temperaturen, usw.) aufweisen. Derart kann die Belastung der Batterie je nach Anwendungsszenario stark variieren. Es könnte dann ein oder mehrere geeignete Anwendungsszenarien aus den möglichen Anwendungsszenarien ausgewählt werden, für den zukünftigen Betrieb. Beispielsweise könnte dasjenige Anwendungsszenario ausgewählt werden, welches mit dem besten zukünftigen Alterungswert assoziiert ist, d.h. beispielsweise noch eine große Restlebensdauer bis zum Lebensendekriterium aufweist. Der zukünftige Alterungswert für dieses ausgewählte Anwendungsszenario kann dann maßgeblich bei der Bestimmung des Zustandswerts berücksichtigt werden.

Als allgemeine Regel sind unterschiedlichste Anwendungsszenarien denkbar. Einige Beispiele werden nachfolgend genannt: stationärer Energiespeicher in einem Mikrostromnetz, beispielsweise um Solarenergie zwischen zu speichern; Energiespeicher für mobile Anwendungen, beispielsweise für leicht Elektrofahrzeuge wie Elektroroller, Elektroräder, etc. oder für Elektropersonenkraftwagen; Niederlastenergiespeicher, beispielsweise im Zusammenhang mit elektronischen Konsumgütern; Innenraumanwendung; Außenanwendung; usw.

Je nach Anwendungsszenario könnte auch vorgesehen werden, dass die Batterie in die unterschiedlichen Bestandteile, das heißt mehrere Batteriezellen zerlegt wird. Eine solche Technik kann insbesondere dann erstrebenswert sein, wenn unterschiedliche Batteriezellen einen unterschiedlichen gegenwärtigen Alterungswert aufweisen, etwa weil sie im historischen Betrieb unterschiedlich stark belastet wurden. In diesem Zusammenhang wäre es denkbar, dass der gegenwärtige Alterungswert, der zukünftige Alterungswert sowie der Zustandswert, der basierend auf den mehreren Alterungskenngrößen ermittelt wird, jeweils für jede von mehreren Zellen der Batterie bestimmt werden.

Dabei wäre es möglich, dass ein bestimmtes Anwendungsszenario aus mehreren Kandidaten-Anwendungsszenarien ausgewählt wird. Diese Auswahl kann in Abhängigkeit von den Zustandswerten, die mit den unterschiedlichen Kandidaten-Anwendungsszenarien assoziiert sind, erfolgen. Die Auswahl könnte auch in Abhängigkeit von den zukünftigen Alterungswerten, die für die mehreren Kandidaten-Anwendungsszenarien bestimmt werden, erfolgen. Es wäre dann denkbar, dass die Batterien in ein Gerät eingebaut wird, das für das jeweils ausgewählte Anwendungsszenario geeignet ist. Es könnten auch unterschiedliche Batteriezellen in unterschiedliche Geräte eingebaut werden, das heißt unterschiedlichen Anwendungsszenarien zugeführt werden. Letzteres kann insbesondere dann hilfreich sein, wenn sich der Zustand Wert für unterschiedliche Batteriezellen signifikant unterscheidet.

Zum Beispiel könnte dasjenige Anwendungsszenario ausgewählt werden, welches eine maximale Restlebensdauer bereitstellt, das heißt dasjenige Anwendungsszenario, welches einen maximalen Abstand zum Lebensende-Kriterium aufweist.

Das Verfahren könnte ferner umfassen: Erfassen von historischen Belastungsprofilen eines Batterieensembles. Das Batterieensemble kann dabei eine Vielzahl von Batterien desselben Typs aufweisen. Es wäre dann denkbar, dass das antizipierten Belastungsprofil der Batterie basierend auf den historischen Belastungsprofilen des Batterieensembles zu bestimmen. Solche Techniken beruhen auf der Erkenntnis, dass es denkbar wäre, dass Batterien desselben Typs und/oder Batterien im selben Anwendungsszenario typischerweise vergleichbare Belastungsprofile aufweisen können. Deshalb kann es möglich sein, dass Belastungsprofil besonders genau zu antizipieren, in dem die historischen Belastungsprofile der anderen Batterien des Ensembles berücksichtigt werden.

Entsprechend wäre es auch denkbar, dass das Alterungsmodell, welches dazu verwendet wird, um den Zustandswert zu ermitteln, basierend auf Information vom Batterieensemble kalibriert wird. Beispielsweise wäre es möglich, dass ein oder mehrere Parameterwerte von Parametern des Alterungsmodells entsprechend bestimmt werden können (Parametrierung). So wird das Alterungsmodell basierend auf kalendarischen und/oder zyklisierten Wertereihen ein oder mehrerer Leistungskenngrößen der Batterien des Batterieensembles parametriert.

Derart kann ein besonders genaues Alterungsmodell erhalten werden. Außerdem kann eine inhärente Vergleichbarkeit zwischen den Zustandsgrößen für unterschiedliche Batterien eines Ensembles erreicht werden. Dies macht die Zustandsgröße besonders zuverlässig.

Es wäre auch denkbar, dass ein Vergleich der Belastungsprofile der jeweiligen Batterie mit einem mittleren Belastungsprofil der Batterien des Batterieensembles durchgeführt wird. Zum Beispiel kann derart festgestellt werden, ob bestimmte Alterungsmechanismen - beispielsweise schnelles Laden, tiefe Temperaturen, besonders große Entladetiefe - vergleichsweise häufig oder selten bei der jeweiligen Batterie aufgetreten sind. Derart kann die Alterung der vorliegenden Batterie abgeschätzt werden, beispielsweise indem im Rahmen des Alterungsmodells ein Vergleich mit dem mittleren Belastungsprofile des Batterieensembles durchgeführt wird.

Grundsätzlich wäre es möglich, dass neben dem (instantanen) gegenwärtigen Alterungswert und dem zukünftigen Alterungswert als weitere Kenngröße auch das historische Belastungsprofil der Batterie beim Ermitteln des Zustandswerts berücksichtigt wird. Dieses kann - wie obenstehend allgemein beschrieben - z.B. als zyklisierte oder kalendarische Wertereihe, und/oder Ereignis-bezogen, und/oder aggregiert vorgehalten werden.

Als allgemeine Regel wäre es möglich, dass der Zustandswert in Abhängigkeit von ein oder mehreren Belastungsprofilen und/oder Alterungswerten für Batterien desselben Typs eines Batterieensembles bestimmt werden. Zum Beispiel wäre es möglich, einen Vergleich zwischen dem Alterungswert und/oder dem zukünftigen Alterungswert für die jeweilige Batterie und einem weiteren Alterungswert und/oder einem weiteren zukünftigen Alterungswert für Batterien desselben Typs eines Batterieensembles durchzuführen. Derart kann zum Beispiel die Alterung der vorliegenden Batterie im Vergleich zur Alterung von vergleichbaren Batterien desselben Typs untersucht werden. Insbesondere wäre es zum Beispiel denkbar, dass aus einem Batterieensemble mit Batterien desselben Typs solche Batterien ausgewählt werden, die ein historisches Belastungsprofil aufweisen, welches vergleichbar ist mit dem historischen Belastungsprofil der zu bewertenden Batterie. Alternativ oder zusätzlich wäre es zum Beispiel denkbar, dass aus einem Batterieensemble mit Batterien desselben Typs solche Batterien ausgewählt werden, die eine vergleichbare Anzahl von Energiedurchsatz aufweisen. Zum Beispiel könnte bei Batterien eines Kraftfahrzeugs solche Batterien ausgewählt werden, die Energie für eine vergleichbare Laufleistung des Kraftfahrzeugs bereitgestellt haben. Derart könnte überprüft werden, ob die zu bewertende Batterie übermäßig gealtert ist, das heißt mehr als - unter Vorliegen des jeweiligen Alterungsprofils - zu erwarten wäre. Eine solche übermäßige Alterung kann darauf hindeuten, dass der Abstand zum Lebensende-Kriterium auch vergleichsweise kurz für die jeweilige Batterie ausfällt.

Solche Techniken beruhen auf der Erkenntnis, dass der Abstand zum Lebensende-Kriterium nicht notwendigerweise nur aus dem gegenwärtigen Alterungswert ersichtlich ist, sondern auch in Abhängigkeit von der Belastungshistorie der Batterie stehen kann und/oder relativen Bezug auf vergleichbare Batterien desselben Typs bewertet werden kann. Außerdem können bestimmte Schadereignisse durch das historische Belastungsprofil abgebildet werden, die den Zustand der Batterie beeinträchtigen.

Es kann also ein multidimensionaler Zustandswert hinsichtlich mehrerer unterschiedlicher Alterungskenngrößen berücksichtigt werden. Zum Beispiel wäre es denkbar, dass für mehrere Alterungskenngrößen jeweils ein Vergleich mit einer Referenz-Alterungskenngröße von Batterien desselben Typs eines Referenz-Batterien Ensembles durchgeführt wird. Dann könnte in Abhängigkeit von diesem Vergleichen der Zustandswert bestimmt werden.

Es wäre als allgemeine Regel denkbar, dass der Zustandswert der Batterie durch Kombination der mehreren Alterungskenngrößen ermittelt wird. Dies bedeutet, dass die Informationsgrundlage zum Ermitteln des Zustandswerts hochdimensional ist; und der Zustandswert dann niederdimensional ausgedrückt wird. Dies kann es ermöglichen, bei einer großen Vielzahl von Batterien den Zustand jeder individuellen Batterie schnell und zuverlässig anhand des einfachen Zustandswerts zu erfassen. Auch automatisierte nachfolgende Anwendungen können auf einen niedrigdimensionalen Zustandswert zurückgreifen.

Dabei kann die Kombination der unterschiedlichen Alterungskenngrößen zum Ermitteln des Zustandswerts auf unterschiedlichste Arten und Weisen erfolgen. Beispielsweise könnte eine gewichtete Kombination erfolgen, wobei Kombinationsgewichte berücksichtigt werden.

Es ist zum Beispiel denkbar (aber nicht notwendig), dass diese Kombinationsgewichte der Kombination der verschiedenen Alterungskenngrößen beim Ermitteln des Zustandswerts basierend auf dem gegenwärtigen Alterungswert und/oder dem zukünftigen Alterungswert ermittelt werden. Zur Illustration folgendes Beispiel: beispielsweise wäre es denkbar, dass der gegenwärtige Alterungswert für eine bisher noch wenig gealterte, junge Batterie stärker berücksichtigt wird, als im Falle einer schon älteren Batterie mit fortgeschrittener Alterung. Dann kann es nämlich besonders wichtig sein, die Alterung auch zukünftig zu antizipieren. Entsprechend könnte in solchen Fällen das Kombinationsgewicht des gegenwärtigen Alterungswerts und des zukünftigen Alterungswerts geeignet angepasst werden.

Ein Computerprogramm oder ein Computerprogrammprodukt oder ein computerlesbares Speichermedium umfasst Programmcode. Der Programmcode kann von einem Prozessor geladen und ausgeführt werden. Wenn der Programmcode von dem Prozessor ausgeführt wird, bewirkt dies, dass der Prozessor ein Verfahren zum Ermitteln eines Zustandswerts ausführt. Der Zustandswert ist im Zusammenhang mit einer Alterung einer wiederaufladbaren Batterie bestimmt. Das Verfahren umfasst das Ermitteln eines gegenwärtigen Alterungswerts der Batterie; das Ermitteln eines zukünftigen Alterungswerts der Batterie mittels eines Alterungsmodells und basierend auf dem gegenwärtigen Alterungswert; sowie das Ermitteln des Zustandswerts der Batterie basierend auf mehreren Alterungskenngrößen. Die mehreren Alterungskenngrößen umfassen zumindest den gegenwärtigen Alterungswert sowie den zukünftigen Alterungswert.

Eine Vorrichtung umfasst einen Prozessor und einen Speicher. Der Prozessor ist eingerichtet, um Programmcode aus dem Speicher zu laden und auszuführen. Wenn der Prozessor den Programmcode ausführt, bewirkt dies, dass der Prozessor ein Verfahren zum Ermitteln eines Zustandswerts im Zusammenhang mit einer Alterung einer wiederaufladbaren Batterie ausführt. Dieses Verfahren umfasst das Ermitteln eines gegenwärtigen Alterungswert der Batterie, sowie das Ermitteln eines zukünftigen Alterungswert der Batterie mittels eines Alterungsmodells und basierend auf dem gegenwärtigen Alterungswert; sowie das Ermitteln des Zustandswerts der Batterie basierend auf mehreren Alterungskenngrößen, die zumindest den gegenwärtigen Alterungswert und den zukünftigen Alterungswert umfassen.

Die oben dargelegten Merkmale sowie Merkmale, die nachfolgend beschrieben werden, können nicht nur in den entsprechenden explizit dargelegten Kombinationen verwendet werden, sondern auch in weiteren Kombinationen oder isoliert, ohne den Schutzumfang der vorliegenden, durch die Ansprüche definierten, Erfindung zu verlassen.

### KURZE BESCHREIBUNG DER FIGUREN

FIG. 1 illustriert schematisch ein System umfassend mehrere Batterien und einen Server gemäß verschiedenen Beispielen.
FIG. 2 illustriert Details einer Batterie gemäß verschiedenen Beispielen.
FIG. 3 illustriert Details eines Servers gemäß verschiedenen Beispielen.
FIG. 4 ist ein Flussdiagramm eines beispielhaften Verfahrens.
FIG. 5 illustriert schematisch einen zukünftigen Alterungswert einer Batterie gemäß verschiedenen Beispielen.
FIG. 6 illustriert schematisch einen zukünftigen Alterungswert einer Batterie gemäß verschiedenen Beispielen.
FIG. 7 illustriert ein aggregiertes Belastungsprofil einer Batterie gemäß verschiedenen Beispielen.
FIG. 8 illustriert schematisch ein Ereignis-basiertes Belastungsprofil einer Batterie gemäß verschiedenen Beispielen.
FIG. 9 ist ein Flussdiagramm eines beispielhaften Verfahrens.
FIG. 10 ist ein Flussdiagramm eines beispielhaften Verfahrens.

### DETAILLIERTE BESCHREIBUNG VON AUSFÜHRUNGSFORMEN

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Repräsentationen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und genereller Zweck dem Fachmann verständlich wird. In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein. Funktionale Einheiten können als Hardware, Software oder eine Kombination aus Hardware und Software implementiert werden.

Nachfolgend werden Techniken im Zusammenhang mit der Charakterisierung von wiederaufladbaren Batterien beschrieben. Die hierin beschriebenen Techniken können im Zusammenhang mit unterschiedlichsten Typen von Batterien eingesetzt werden, beispielsweise im Zusammenhang mit Batterien auf Lithium-Ionen-Basis, wie z.B. Lithium-Nickel-Mangan-Cobaltoxid-Batterien oder Lithium-Manganoxid-Batterien.

Die hierin beschriebenen Batterien können für Batterien in unterschiedlichen Anwendungsszenarien eingesetzt werden, beispielsweise für Batterien die in Geräten wie Kraftfahrzeugen oder Drohnen oder tragbaren elektronischen Geräten wie etwa Mobilfunkgeräte eingesetzt werden. Es wäre auch denkbar, die hierin beschriebenen Batterien in Form von stationären Energiespeichern einzusetzen. Innenraum- oder Außenraumanwendungen sind denkbar, die sich vor allem hinsichtlich der Temperaturbereiche unterscheiden. Anwendungsszenarien umfassen: stationärer Energiespeicher in einem Mikrostromnetz; Energiespeicher für mobile Anwendungen; Niederlastenergiespeicher; Energiespeicher für Leichtelektrofahrzeuge; Energiespeicher für Elektropersonenkraftwagen; Innenraumanwendung; und Außenraumanwendung.

Die hierin beschriebenen Techniken ermöglichen es, im Zusammenhang mit der Charakterisierung der Batterie einen Zustandswert der Batterie zu ermitteln. Der Zustandswert korreliert mit der Alterung der wiederaufladbaren Batterie. Der Zustandswert kann die Qualität der Batterie beschreiben (und könnte deshalb auch als Q-Wert bezeichnet werden).

Gemäß verschiedenen hierin beschriebenen Beispielen werden mehrere Alterungskenngrößen der Batterie beim Ermitteln des Zustandswerts berücksichtigt. Es kann insbesondere ein gegenwärtiger Alterungswert der Batterie berücksichtigt werden, sowie ein zukünftiger Alterungswert der Batterie. Der zukünftige Alterungswert kann mittels eines Alterungsmodells erhalten werden. Dies entspricht einer Vorhersage von Leistungskenngrößen der Batterie. Ein oder mehrere Leistungskenngrößen können für ein gewisses Vorhersageintervall antizipiert werden. Es könnten auch noch weitere oder andere Alterungskenngrößen berücksichtigt werden, z.B. ein historischen Belastungsprofil bzw. ein historischer Alterungswert, der daraus abgeleitet wird.

Als allgemeine Regel könnte z.B. eine Kombination der mehreren Alterungskenngrößen erfolgen, z.B. eine gewichtete Kombination. Je nach Einfluss der jeweiligen Alterungskenngröße, kann diese stärker oder schwächer berücksichtigt werden.

Solche Techniken beruhen auf der Erkenntnis, dass beispielsweise Lithiumionen-Batterien oder andere wiederaufladbare Batterien sowohl durch Nutzung (zyklische Alterung), wie auch durch Lagerung (kalendarische Alterung) altern können. Die Alterung spiegelt sich in Form eines Kapazitätsverlust und eines Impedanzanstiegs wider. Dies wird typischerweise durch den SOH erfasst. Dabei hängt die Alterung aber von vielen Faktoren ab, beispielsweise Stressfaktoren wie Temperatur, Ladungszustand, Entladungstiefe, Stromrate beim Entladen und Laden, etc. Die Alterung kann ferner durch unterschiedliche Alterungsmechanismen ablaufen, beispielsweise Solid Electrolyte Interface (SEI)-Schicht-Wachstum oder Lithium-Ablagerung (engl. Lithium-Plating).

Es wurde erkannt, dass die im bisherigen Betrieb aufgetretenen Alterungsmechanismen auch den zukünftigen weiteren Verlauf der Alterung beeinflussen können. Zum Beispiel begünstigt bereits aufgetretene Lithium-Abscheidung eine weitere fortgesetzte Lithium-Abscheidung in der Zukunft und somit einen (noch) schnelleren Kapazitätsverlust, bei einem sonst unverändertem Belastungsprofil.

Als Folge solcher Gegebenheiten ist die Beurteilung des Zustands der Batterie und damit die verbleibende Lebensdauer auf Grundlage eines einzelnen, gegenwärtigen Alterungswerts oftmals nicht oder nur eingeschränkt möglich. Daher kann zum Beispiel der Restwert der Batterie nicht oder nur ungenau bestimmt werden. Auch die Eignung für weitere Anwendungsszenarien, zum Beispiel eine Second-Life-Anwendung der Batterie, kann auf Grundlage des gegenwärtigen Alterungswerts nicht oder nur ungenau bestimmt werden.

Mittels der hierin beschriebenen Techniken ist es möglich, eine fundierte Aussage über den Zustand der Batterie zu treffen. Der Zustandswert der Batterie wird basierend auf mehreren Alterungskenngrößen ermittelt. Derart kann beispielsweise ein niederdimensionaler Faktor erhalten werden, der eine einfache Quantifizierung und Kontrolle von Prozessen, die von der Batterie abhängig sind, ermöglicht. Ein sogenannter Belastungsindex oder Qualitätsindex könnte erstellt werden.

Der Zustandswert könnte dazu verwendet werden, um die ordnungsgemäße Nutzung der Batterie zu überprüfen. Beispielsweise könnten Garantiefälle aufgedeckt oder reguliert werden. Dies kann zum Beispiel dadurch erfolgen, dass die Zustandswerte von vielen Batterien eines Ensembles miteinander verglichen werden. Wenn im Rahmen eines solchen Vergleichs eine Abweichung des Zustandswerts von den übrigen Zustandswerten erkannt wird, könnte eine Warnung ausgegeben werden. Indem der niedrigdimensionale Zustandswert verglichen wird, kann der Vergleich schnell und robust erfolgen.

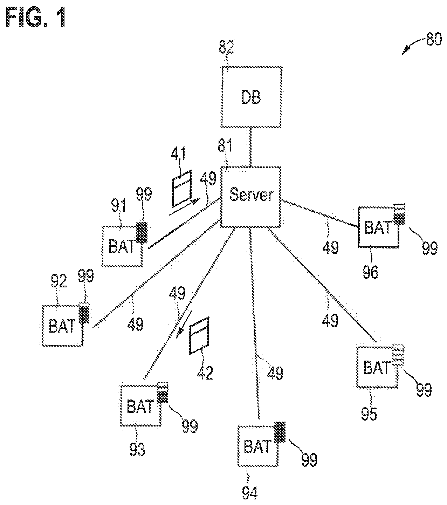

FIG. 1 illustriert Aspekte im Zusammenhang mit einem System 80. Das System 80 umfasst einen Server 81, der mit einer Datenbank 82 verbunden ist. Außerdem umfasst das System 80 Kommunikationsverbindungen 49 zwischen dem Server 81 und jeder von mehreren Batterien 91-96. Die Kommunikationsverbindungen 49 könnten zum Beispiel über ein Mobilfunknetzwerk implementiert werden. Beispielsweise können die Batterien 91-96 ein Ensemble bilden, d.h. alle vom gleichen Typ sein.

In FIG. 1 ist beispielhaft illustriert, dass die Batterien 91-96 über die Kommunikationsverbindungen 49 Zustandsdaten 41 an den Server 81 senden können. Beispielsweise wäre es möglich, dass die Zustandsdaten 41 indikativ sind für ein historisches Belastungsprofil, zum Beispiel ein Ereignis-bezogenes Belastungsprofil und/oder ein kollektives Belastungsprofil, der jeweiligen Batterie 91-96 sind oder indikativ für entsprechende Leistungsgrößen. Eine beispielhafte Leistungsgröße ist der SOH der jeweiligen Batterie 91-96; dieser wird bestimmt basierend auf oder entspricht der Kapazität der jeweiligen Batterie 91-96 und/oder der Impedanz der jeweiligen Batterie 91-96. Der SOH dient als Alterungswert der Batterie. Weitere Beispiele für Leistungskenngrößen sind eine Lade- oder Entladerate, Temperatur, Entladungstiefe, usw.

In FIG. 1 ist auch beispielhaft illustriert, dass der Server 81 über die Kommunikationsverbindungen 49 Steuerdaten 42 an die Batterien 91-96 senden kann. Beispielsweise wäre es möglich, dass die Steuerdaten 42 ein oder mehrere Betriebsgrenzen für den zukünftigen Betrieb der jeweiligen Batterie 91-96 indizieren. Zum Beispiel könnten die Steuerdaten ein oder mehrere Steuerparameter für ein Thermomanagement der jeweiligen Batterie 91-96 und/oder ein Lademanagement der jeweiligen Batterie 91-96 indizieren. Durch Verwendung der Steuerdaten 42 kann der Server 81 also den Betrieb der Batterien 91-96 beeinflussen bzw. steuern. Dies könnte z.B. basierend auf einem Zustandswert, der vom Server 81 für die jeweilige Batterie ermittelt wird.

In FIG. 1 ist außerdem für jede der Batterien 91-96 schematisch ein jeweiliger Zustandswert 99 illustriert. Nachfolgend werden Techniken zur Ermittlung des Zustandswerts 99 beschrieben.

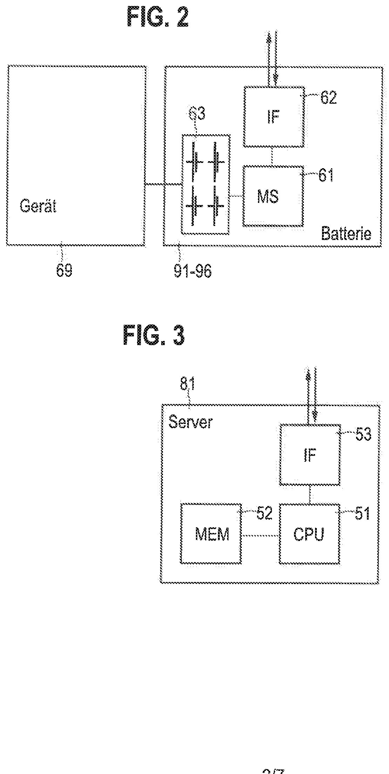

FIG. 2 illustriert Aspekte im Zusammenhang mit den Batterien 91-96. Die Batterien 91-96 sind mit einem jeweiligen Gerät 69 gekoppelt. Dieses Gerät wird durch elektrische Energie aus der jeweiligen Batterie 91-96 getrieben.

Die Batterien 91-96 umfassen bzw. sind assoziiert mit ein oder mehreren Managementsysteme 61, z.B. ein BMS oder eine andere Steuerlogik wie eine onboard-unit im Falle eines Fahrzeugs. Das Managementsystem 61 kann zum Beispiel durch Software auf einem CPU implementiert sein. Alternativ oder zusätzlich könnte zum Beispiel ein Applikations-spezifischer Schaltkreis (ASIC) oder ein Feldprogrammierbares gated array (FPGA) verwendet werden. Die Batterien 91-96 könnten z.B. über ein Bussystem mit dem Managementsystem 61 kommunizieren. Die Batterien 91-96 umfassen auch eine Kommunikationsschnittstelle 62. Das Managementsystem 61 kann über die Kommunikationsschnittstelle 62 eine Kommunikationsverbindung 49 mit dem Server 81 aufbauen.

Während in FIG. 2 das Managementsystem 61 separat von den Batterien 91-96 gezeichnet ist, wäre es in anderen Beispielen auch möglich, dass das Managementsystem 61 Teil der Batterien 91-96 ist.

Außerdem umfassen die Batterien 91-96 ein oder mehrere Batterieblöcke 63. Jeder Batterieblock 63 umfasst typischerweise eine Anzahl von parallel geschalteten und/oder seriell geschalteten Batteriezellen. Dort kann elektrische Energie gespeichert werden.

Typischerweise kann das Managementsystem 61 auf ein oder mehrere Sensoren in den ein oder mehreren Batterieblöcken 63 zurückgreifen. Die Sensoren können zum Beispiel Leistungskenngrößen der jeweiligen Batterie messen, etwa den Stromfluss und/oder die Spannung in zumindest einigen der Batteriezellen. Die Sensoren können alternativ oder zusätzlich auch andere Leistungskenngrößen im Zusammenhang mit zumindest einigen der Batteriezellen messen, beispielsweise Temperatur, Volumen, Druck, etc. Das Managementsystem 61 kann dann eingerichtet sein, um auf Grundlage von ein oder mehreren solchen Messwerten von Sensoren einen aktuellen SOH für die jeweilige Batterie 91-96 bzw. optional auch für individuelle Batterieblöcke zu bestimmen, d.h. also zum Beispiel die elektrische Kapazität und/oder die elektrische Impedanz der Batterie zu bestimmen und in Form von Betriebsdaten an den Server 81 zu senden. All solche Größen werden als Leistungsgrößen bezeichnet.

FIG. 3 illustriert Aspekte im Zusammenhang mit dem Server 81. Der Server 81 umfasst einen Prozessor 51 sowie einen Speicher 52. Der Speicher 52 kann ein flüchtiges Speicherelement und/oder ein nicht-flüchtiges Speicherelement umfassen. Außerdem umfasst der Server 81 auch eine Kommunikationsschnittstelle 53. Der Prozessor 51 kann über die Kommunikationsschnittstelle 53 eine Kommunikationsverbindung 49 mit jeder der Batterien 91-96 und der Datenbank 82 aufbauen.

Zum Beispiel kann Programmcode im Speicher 52 gespeichert sein und vom Prozessor 51 geladen werden. Der Prozessor 51 kann dann den Programmcode ausführen. Das Ausführen des Programmcodes bewirkt, dass der Prozessor 51 ein oder mehrere der folgenden Prozesse ausführt, wie sie im Zusammenhang mit den verschiedenen Beispielen hierin im Detail beschrieben sind: Charakterisierung von Batterien 91-96; Ermitteln eines Zustandswerts 99 für die Batterien 91-96; Ermitteln von Alterungswerten für die Batterien 91-96; Anwenden eines Alterungsmodells; z.B. mit einer oder mehreren Simulationen; Durchführen einer elektrischen Simulation von Batterien 91-96 im Zusammenhang mit dem Alterungsmodell; Durchführen einer thermischen Simulation von Batterien 91-96 im Zusammenhang mit dem Alterungsmodell; Senden von Steuerdaten an Batterien 91-96, zum Beispiel um Betriebsrandbedingungen einzustellen; Hinterlegen von einem Ergebnis einer Charakterisierung einer entsprechenden Batterie 91-96 in einer Datenbank 82; etc..

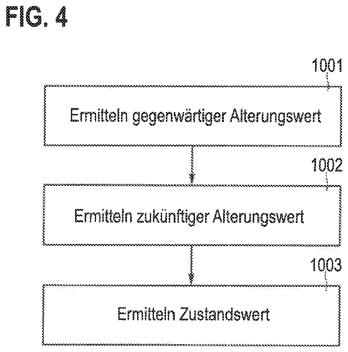

FIG. 4 ist ein Flussdiagramm eines beispielhaften Verfahrens. Das Verfahren wird von einem Server ausgeführt. Das Verfahren dient der Server-seitigen Charakterisierung einer Batterie. Zum Beispiel wäre es möglich, dass das Verfahren gemäß FIG. 4 vom Prozessor 51 des Servers 81 basierend auf Programmcode aus dem Speicher 52 ausgeführt wird (vgl. FIG. 3).

Zunächst wird in Block 1001 ein gegenwärtiger Alterungswert der Batterie ermittelt. Beispielsweise könnten dazu Zustandsdaten 41 von der jeweiligen Batterie 91-96 empfangen werden (vgl. FIG. 1). Beispielsweise könnte der gegenwärtige Alterungswert dem SOH entsprechen. Es wäre möglich, dass der SOH bereits in Form der Zustandsdaten 41 von der jeweiligen Batterie 91-96 empfangen wird, oder aber aus ein oder mehreren anderen Leistungskenngrößen der jeweiligen Batterie 91-96 abgeleitet wird.

Anschließend wird in Block 1002 ein zukünftiger Alterungswert der jeweiligen Batterie ermittelt. Dazu wird ein Alterungsmodell verwendet.

Als allgemeine Regel kann das Alterungsmodell eine thermische und eine elektrische Simulation umfassen. Der zukünftige Alterungswert kann ferner auch basierend auf dem gegenwärtigen Alterungswert aus Block 1001 bestimmt werden.

Schließlich erfolgt in Block 1003 das Ermitteln eines Zustandswerts der Batterie. Dies basiert auf dem gegenwärtigen Alterungswert aus Block 1001, sowie auf dem zukünftigen Alterungswert aus Block 1002. Beispielsweise könnten alternativ oder zusätzlich zu solchen Alterungskenngrößen aber auch weitere Alterungskenngrößen bei der Ermittlung des Zustandswerts in Block 1003 berücksichtigt werden.

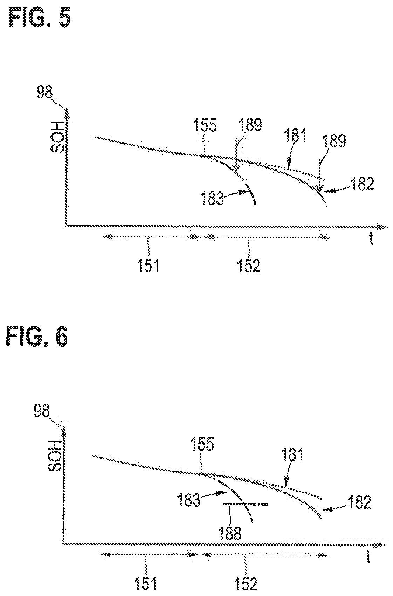

Der Zustandswert kann also eine Kombination von mehreren Alterungskenngrößen umfassen. Der Zustandswert kann also beispielsweise eine Kombination des gegenwärtigen Alterungswerts und des zukünftigen Alterungswerts umfassen. Damit kann der Zustandswert besonders aussagekräftig und genau den Zustand der Batterie widerspiegeln. Eine entsprechende Motivation ist im Zusammenhang mit FIG. 5 illustriert.

FIG. 5 illustriert Aspekte im Zusammenhang mit der Charakterisierung des Zustands der Batterie. FIG. 5 illustriert einen Alterungswert 98 der Batterie - hier der SOH - als Funktion der Zeit, etwa der Betriebszeit. Ein vergleichbares Szenario würde sich aber auch bei Betrachtung des Alterungswerts 98 als Funktion der Lade- und Entladezyklen ergeben (zyklisierte Alterung). Das historische Betriebsintervall 151 und ein zukünftiges Betriebsintervall 152 des Betriebs der jeweiligen Batterie 91-96 sind in FIG. 5 auch gezeigt.

In FIG. 5 ist dargestellt, dass der SOH 98 als Funktion der Zeit abnimmt. Der SOH 98 zum IST-Zeitpunkt 155 ist in FIG. 5 hervorgehoben (gegenwärtiger Alterungswert).

In FIG. 5 sind außerdem drei Pfade 181-183 für den zukünftigen Alterungswert 98 im Vorhersageintervall 152 dargestellt. Aus FIG. 5 ist ersichtlich, dass die entsprechende Wertereihe des zukünftigen Alterungswerts 98 der verschiedenen Pfade 181-183 jeweils eine sprunghafte Abnahme aufweist (für die Pfade 182-183 in FIG. 5 mit den vertikalen Pfeilen gekennzeichnet). Diese sprunghafte Abnahme ist die Signatur eines Lebensende-Kriteriums 189.

Aus FIG. 5 ist ersichtlich, dass die restliche Lebensdauer als Abstand zwischen dem IST-Zeitpunkt 155 und dem Lebensende-Kriterium 189 je nach Pfad 181-183 unterschiedlich ist. Dies kann in den verschiedenen hierin beschriebenen Techniken dadurch berücksichtigt werden, dass der zukünftige Alterungswert - beispielsweise also eine Wertereihe des SOH 98 wie in FIG. 5 dargestellt, oder im Allgemeinen eine kalendarische und/oder zyklisierte Wertereihe von ein oder mehrere Leistungskenngrößen der jeweiligen Batterie 91-96 - bei der Ermittlung des Zustandswerts 99 der Batterie berücksichtigt wird. Insbesondere könnte die verbleibende Lebensdauer als Abstand zum Lebensende-Kriterium 189 bei der Ermittlung des Zustandswerts berücksichtigt werden, etwa indem eine Analyse der jeweiligen Wertereihe zum Erkennen der entsprechenden Signatur durchgeführt wird.

Während im Zusammenhang mit FIG. 5 das Lebensende-Kriterium 189 im Zusammenhang mit der sprunghaften Abnahme des SOH 98 diskutiert wurde, sind im Allgemeinen auch andere Lebensende-Kriterien denkbar. Beispielsweise könnte eine entsprechende Signatur die Abnahme der Kapazität als eine entsprechende Leistungskenngröße unter einen vorgegebenen Schwellenwert umfassen. Das ist für einen Schwellenwert 188 in FIG. 6 dargestellt.

Die verschiedenen Pfade 181-183 können sich aus der Berücksichtigung unterschiedlicher Belastungsprofile ergeben. Als allgemeine Regel können die Belastungsprofile spezifizieren, wie häufig und/oder wie stark die Batterie belastet wird. Beispielsweise könnte das Belastungsprofil der jeweiligen Batterie 91-96 bestimmte Randbedingungen für die Leistungskenngrößen der Batterie bestimmen, also zum Beispiel spezifizieren, wie häufig eine starke Tiefenentladung auftritt, was ein durchschnittlicher Ladungszustand der Batterie ist, bei welcher Umgebungstemperatur die Batterie betrieben wird, usw.. Als allgemeine Regel können für das historische Intervall 151 ein historisches Belastungsprofil verwendet werden und für das Vohersageintervall ein antizipiertes Belastungsprofil verwendet werden.

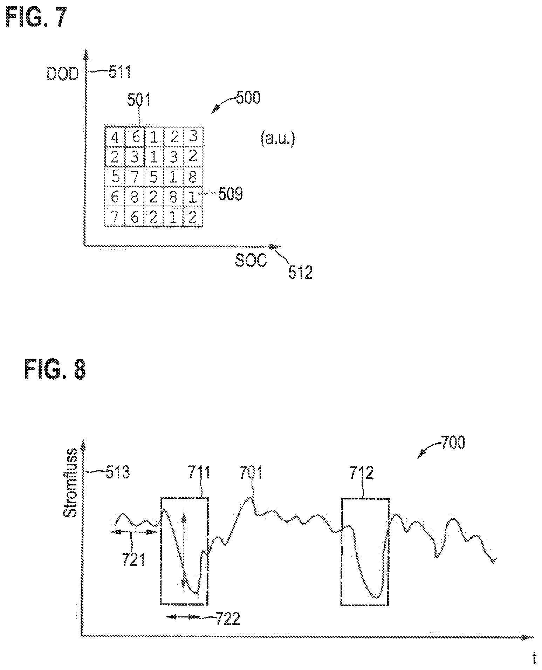

Ein entsprechendes Beispiel für ein Belastungsprofil 500 ist in FIG. 7 dargestellt.

FIG. 7 illustriert Aspekte im Zusammenhang mit einem Belastungsprofil 500. Beispielsweise könnte das Belastungsprofile 500 ein historisches Belastungsprofil während des historischen Zeitintervalls 151 (vergleiche FIG. 5 und FIG. 6) sein. Es wäre aber auch möglich, dass das Belastungsprofil 500 ein antizipiertes Belastungsprofil während des Vorhersageintervalls 152 ist.

FIG. 7 illustriert ein aggregiertes Belastungsprofile 500. Das bedeutet, dass die Häufigkeit 509 bestimmter Leistungskenngrößen, in FIG. 7 Entladungstiefe 511 (DOD) und Ladungszustand 512 (SOC) angegeben ist. Im Beispiel der FIG. 7 illustriert das Belastungsprofil 500 außerdem einen vorgegebenen Bereich 501, für besonders große Entladungstiefen 511 bei geringen SOC 512 (andere vorgegebene Bereiche wären denkbar). Das Belastungsprofil 500 indiziert insbesondere die Häufigkeit des Betriebs der jeweiligen Batterie im vorgegebenen Bereich. Zum Beispiel wäre es denkbar, dass der vorgegebene Bereich mit einer irreversiblen Lithium-Ablagerung an einer Elektrode der Batterie assoziiert ist.

Neben einem solchen aggregierten Belastungsprofil 500 sind auch andere Implementierungen für das Belastungsprofil denkbar. Ein entsprechendes Beispiel ist in FIG. 8 dargestellt.

FIG. 8 illustriert Aspekte im Zusammenhang mit einem Belastungsprofil 700. In FIG. 8 ist der Stromfluss 513 als Leistungskenngröße der jeweiligen Batterie als Funktion der Zeit dargestellt. Insbesondere illustriert FIG. 8 ein Belastungsprofil 700, welches eine entsprechende Wertereihe 701 umfasst.

Außerdem ist in FIG. 8 dargestellt, dass es möglich sein kann, ein Ereignis-basiertes Belastungsprofil zu verwenden. Es wäre zum Beispiel möglich, die Ereignisse 711, nämlich eine plötzliche Abnahme des Stromflusses 513 während eines Zeitintervalls 722, folgend auf ein Zeitintervall 721 mit relativ konstantem Stromflusses 513 zu definieren. Beispielsweise könnte die Häufigkeit solcher Ereignisse 711-712 im Rahmen eines Ereignis-basierten Belastungsprofils gezählt werden.

Solche Belastungsprofile 500, 700 können auf unterschiedlichste Arten und Weisen in den hierin beschriebenen Techniken berücksichtigt werden.

Als erstes Beispiel könnte ein solches historisches Belastungsprofil 500, 700 - während des historischen Intervalls 151 - als Alterungskenngröße bei der Ermittlung des Zustandswerts 99 berücksichtigt werden.

Als zweites Beispiel könnte das historische Belastungsprofil 500, 700 bei der Ermittlung eines antizipierten Belastungsprofils 500, 700 während des Vorhersageintervalls 152 berücksichtigt werden.

Als drittes Beispiel wäre es möglich, historische Belastungsprofile von Batterien eines Batterieensembles zu erfassen und dann das antizipierte Belastungsprofil der jeweiligen Batterie basierend auf diesen historischen Belastungsprofilen zu bestimmen.

Als viertes Beispiel könnte das Alterungsmodell unter Verwendung eines entsprechenden antizipierten Belastungsprofils 500, 700 ausgeführt werden. Dies bedeutet also in anderen Worten, dass beim Ermitteln des zukünftigen Alterungswerts (vgl. FIG. 4: Block 1002) das antizipierte Belastungsprofil berücksichtigt wird. Dabei könnte das antizipierte Belastungsprofil beispielsweise in Abhängigkeit von einem historischen Belastungsprofil 500, 700 und/oder von Belastungsprofilen anderer Batterien 91-96 eines Batterieensembles bestimmt werden.

Ein fünftes Beispiel zur Berücksichtigung eines Belastungsprofils wäre, dass das Lebensende-Kriterium im Zusammenhang mit dem antizipierten Belastungsprofil definiert ist. Beispielsweise könnte der Schwellenwert 188 (vgl. FIG. 6) oder die Abknick-Signatur 189 in Abhängigkeit von dem antizipierten Belastungsprofil der Batterie bestimmt werden.

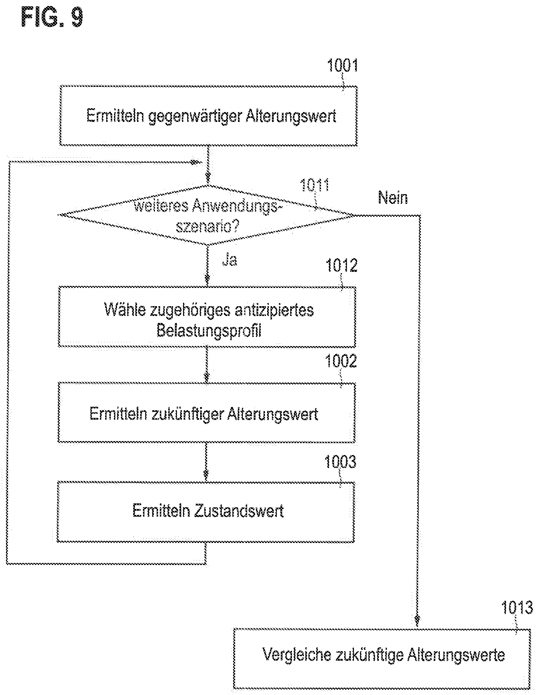

Noch ein weiteres Beispiel zur Berücksichtigung eines Belastungsprofils ist in FIG. 9 dargestellt. FIG. 9 ist ein Flussdiagramm eines beispielhaften Verfahrens. Das Verfahren aus FIG. 9 entspricht grundsätzlich dem Verfahren aus FIG. 4. Dabei wurde das Verfahren aus FIG. 4 dahingehend modifiziert, dass mehrere Iterationen der Blöcke 1002 und 1003 durchgeführt werden, das heißt es werden mehrere zukünftige Alterungswerte ermittelt und es werden, basierend auf den mehreren zukünftigen Alterungswerten aus den verschiedenen Iterationen von Block 1002 auch mehrere Zustandswerte in den Iterationen von Block 1003 ermittelt.

Von Iteration zu Iteration wird jeweils das zugehörige antizipierte Belastungsprofil 500, 700 variiert, indem Block 1012 ausgeführt wird. Die verschiedenen, in den mehreren Iterationen von Block 1012 ausgewählten antizipierten Belastungsprofile 500, 700 korrelieren dabei mit verschiedenen Anwendungsszenarien im Vorhersageintervall 152. Typischerweise weisen unterschiedliche Anwendungsszenarien nämlich unterschiedliche Belastungsprofile auf. Es gibt weniger belastende Anwendungenszenarien, beispielsweise für stationäre Energiespeicher in einem Mikrostromnetz; und es gibt auch besonders belastende Anwendungsszenarien, beispielsweise Energiespeicher für Elektropersonenkraftwagen. Die verschiedenen Anwendungsszenarien werden jeweils in Block 1011 abgefragt und ausgewählt.

In Bock 1013 wäre es dann möglich, die verschiedenen zukünftigen Alterungswerte, aus den Iterationen von Block 1002, miteinander zu vergleichen. Es wäre dann möglich, ein oder mehrere zukünftige Alterungswerte basierend auf diesem Vergleich auszuwählen und bei der Ermittlung des Zustandswerts 99 zu berücksichtigen. Z.B. könnte bei einer Worst-Case-Betrachtung der schlechteste zukünftige Alterungswert berücksichtigt werden, d.h. derjenige, der der schnellsten / stärksten Alterung entspricht. Es könnte aber auch ein Mittelwert der verschiedenen zukünftigen Alterungswerte berücksichtigt werden oder eine Varianz.

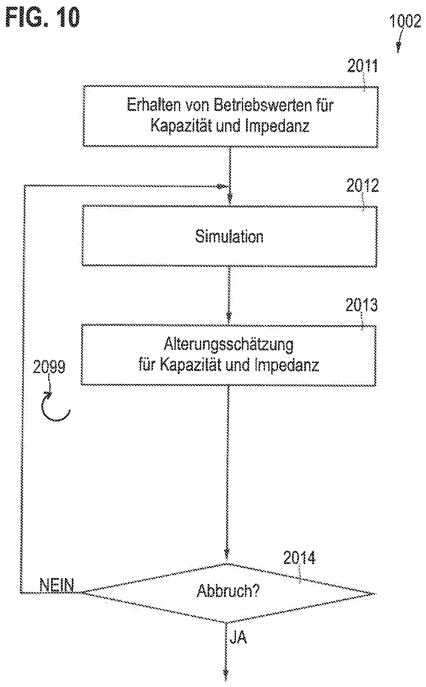

Nachfolgend wird die Implementierung des Alterungsmodells beschrieben, nämlich anhand des Flussdiagramms in FIG. 10.

FIG. 10 ist ein Flussdiagramm eines beispielhaften Verfahrens. Das Verfahren nach FIG. 10 kann von einem Server ausgeführt werden. Zum Beispiel wäre es möglich, dass das Verfahren gemäß FIG. 10 vom Prozessor 51 des Servers 81 basierend auf Programmcode aus dem Speicher 52 ausgeführt wird (vgl. FIG. 3).

Das Verfahren gemäß FIG. 10 dient der Ermittlung des zukünftigen Alterungswerts der Batterie mittels des Alterungsmodells. Wenn mehrere zukünftige Alterungswerte vorhergesagt (vgl. FIG. 9) werden sollen, wird das Verfahren nach FIG. 10 mehrfach durchgeführt.

In Block 2011 werden zunächst die Betriebswerte für die Kapazität und die Impedanz der jeweiligen Batterie erhalten. Dies bedeutet, dass ein aktueller Wert für den SOH der Batterie erhalten wird. Dies geschieht typischerweise basierend auf Zustandsdaten die vom jeweiligen Managementsystem, das mit der entsprechenden Batterie assoziiert ist, empfangen werden. Diese Betriebswerte dienen der Initialisierung der Zustandsvorhersage.

Dann werden mehrere Iterationen 2099 der Blöcke 2012-2014 durchgeführt. Die verschiedenen Iterationen 1099 entsprechen dabei Zeitschritten für die Zustandsvorhersage, d.h. fortschreitender Zeit während des Vorhersageintervalls 152.

Dabei erfolgt zunächst in Block 2012 die Simulation eines elektrischen Zustands der Batterie und eines thermischen Zustands der Batterie mittels entsprechender Simulationsmodule, für den jeweiligen Zeitschritt der entsprechenden Iteration 2099.

In Block 2012 erfolgt die Simulation unter Berücksichtigung des entsprechenden antizipierten Belastungsprofils 500, 700 der Batterie.

Zur Simulation des elektrischen und thermischen Zustands kann ein elektrisches Simulationsmodul gekoppelt werden mit einem thermischen Simulationsmodul.

Das elektrische Simulationsmodul kann ein Ersatzschaltkreismodell (ECM) für die Batterie verwenden. Das ECM kann elektrische Bauelemente (Widerstand, Induktivität, Kapazität) umfassen. Die Parameter der Bauelemente des ECM können z.B. anhand eines Nyquist-Plots mit den charakteristischen Frequenzbereichen des Übertragungsverhaltens des Zellblocks der Batterie bestimmt werden. Durch die Implementierung auf dem Server 81 kann die Anzahl der RC-Glieder besonders hoch gewählt werden, z.B. größer als drei oder vier. Dadurch kann eine besonders hohe Genauigkeit der elektrischen Simulation erzielt werden. Dabei kann je ein ECM für jede Zelle eines Zellblocks verwendet werden. Dabei ist das ECM nur ein Beispiel; es sind auch andere Implementierungen möglich, z.B. ein elektro-chemisches Modell.

Das thermische Simulationsmodell ermöglicht es, den zeitlichen Temperaturverlauf und optional die lokale Temperatur zu bestimmen. Dabei können Wärmequellen und Wärmesenken berücksichtigt werden. Die Wärmeabgabe an die Umgebung kann berücksichtigt werden. Details zu Wärmegenerationsmodell sind z.B. beschrieben in: D. Bernandi, E. Pawlikowski, und J. Newman, "A General Energy Balance for Battery Systems," Journal of the Electrochemical Society, 1985. Es können analytische oder numerische Modelle für die lokale Temperaturverteilung verwendet werden. Der Einfluss ein Thermomanagements kann berücksichtigt werden. Sh. z.B. M.-S. Wu, K. H. Liu, Y.-Y. Wang, und C.-C. Wan, "Heat dissipation design for lithium-ion batteries," Journal of Power Sources, Bd. 109, Rn. 1, S. 160-166, 2002.

Darauf basierend wird dann in Block 2013 eine Alterungsschätzung durchgeführt, d.h. die Kapazität und die Impedanz der Batterie werden für den jeweiligen Zeitschritt basierend auf einem Ergebnis der Simulation des elektrischen Zustands und des thermischen Zustands der Batterie bestimmt.

Im Zusammenhang mit der Alterungsschätzung können unterschiedliche Techniken verwendet werden. Die Alterungsschätzung kann zum Beispiel eine empirische Alterungsmodellgleichung und/oder eine maschinengelernte Alterungsmodellgleichung umfassen. Zum Beispiel könnten eine empirische Alterungsmodellgleichung und eine maschinengelernte Alterungsmodellgleichung parallel angewendet werden und dann Ergebnisse dieser beiden Alterungsmodellgleichungen durch Mittelung, beispielsweise gewichtete Mittelung, zusammengeführt werden.

Als allgemeine Regel könnte die empirische Alterungsmodellgleichung ein oder mehrere empirisch bestimmte Parameter umfassen, welche das antizipierte Belastungsprofil in Bezug setzen zu einer Verschlechterung des SOH, beispielsweise einer Herabsetzung der Kapazität und/oder Erhöhung der Impedanz. Die Parameter können zum Beispiel in Labormessungen bestimmt werden. Ein beispielhaftes empirisches Alterungsmodell ist beschrieben in: J. Schmalstieg, S. Käbitz, M. Ecker, und D. U. Sauer, "A holistic aging model for Li(NiMnCo)O2 based 18650 lithium-ion batteries," Journal of Power Sources, Bd. 257, S. 325-334, 2014. Es wäre auch möglich, die empirische Alterungsmodellgleichung zu parametrieren, indem auf kalendarische und/oder zyklisierte Wertereihen entsprechender Alterungskenngrößen der Batterie im historischen Intervall 151 zurückgegriffen wird.

Eine maschinengelernte Alterungsmodellgleichung kann kontinuierlich auf Grundlage von Zustandsdaten, die von unterschiedlichen Batterien desselben Typs erhalten werden, durch maschinelles Lernen angepasst werden. Auch hier können solche Wertereihen berücksichtigt werden. Zum Beispiel könnten künstliche neuronale Netzwerke, etwa Faltungsnetzwerk (engl. convolutional neural network), verwendet werden. Eine andere Technik umfasst die sogenannte Stützvektormethode (engl. support vector machine). Zum Beispiel können Daten von einem Ensemble von Batterien (vergleiche FIG. 1: Batterien 91-96) verwendet werden, um einen entsprechenden Algorithmus durch maschinelles Lernen zu trainieren.

Anschließend wird in Block 2014 überprüft, ob ein Abbruchkriterium erfüllt ist. Sofern dies nicht der Fall ist, wird Block 2012 erneut durchgeführt, für einen nächsten Zeitschritt im Vorhersageintervall 152, d.h. für die nächste Iteration 2099. Dabei werden die in der vorherigen Iteration 2099 bestimmten Kapazitäten und Impedanzen verwendet, d.h. die Simulationen in Block 2012 bauen aufeinander auf. Diese iterative Anpassung von Kapazität und Impedanz ermöglicht eine besonders genaue Zustandsvorhersage.

Wenn das Abbruchkriterium in Block 2014 erfüllt ist, kann der zukünftige Alterungswert ermittelt werden. Beispiele für Abbruchkriterien umfassen: Anzahl von Iterationen 1099; Ende des Vorhersageintervalls 152 erreicht; Überschreitung bzw. Unterschreitung von Schwellenwerten für die Kapazität und/oder die Impedanz; Erreichen eines Lebensende-Kriteriums; etc.

Zusammenfassend wurden voranstehend Techniken zur Charakterisierung einer Batterie bestimmt. Dabei wird ein Zustandswert basierend auf mehreren Alterungskenngrößen bestimmt. Insbesondere kann auch ein zukünftiger Alterungswert der Batterie als Alterungskenngröße berücksichtigt werden.

Mittels solcher Techniken kann eine besonders genaue Beurteilung des Restwerts von Batterien für deren jeweiliges Anwendungsszenario erfolgen. Es ist möglich, ein geeignetes zukünftiges Anwendungsszenario, beispielsweise ein Second-Life-Anwendungsszenario, auszuwählen. Der Zustand mehrerer Batterien kann miteinander verglichen werden. Garantiefälle können erkannt werden. Zum Beispiel wäre es möglich, dass unterschiedliche Anwendungsszenarien, aus denen das zukünftige Anwendungsszenario ausgewählt wird, sich hinsichtlich eines Verbrauchers, der die Energie aus der Batterie erhält, unterscheiden. Die verschiedenen Anwendungsszenarien können sich hinsichtlich des Belastungsprofils unterscheiden. Zum Beispiel könnte die Batterie in unterschiedlichen Geräten eingebaut werden. Es wäre zum Beispiel denkbar, dass je nach Auswahl die Batterie und/oder Batteriezellen der Batterie in verschiedene Geräte eingebaut werden. Dabei können unterschiedliche Anwendungsszenarien mit unterschiedlichen Geräten assoziiert sein. Zum Beispiel könnte ein Gerät für ein Anwendungsszenario "Mikrostromnetz" mit einem Energiezwischenspeicher-Gerät für die ortsfeste Montage assoziiert sein. Das Anwendungsszenario "Energiespeicher für Leichtelektrofahrzeuge" könnte zum Beispiel mit einem Elektroroller oder Hoverboard assoziiert sein.

Ein weiteres Beispiel für ein Anwendungsszenario-spezifisches Gerät sind Großspeicher für Primärleistung oder Sekundärleistung oder Peakshaving. Ein Großspeicher kann zur Speicherung von regenerativ erzeugter elektrischen Energie eingesetzt werden, etwa aus Fotovoltaik. Typischerweise treten dort geringere Lade- und/oder Entladeleistungen, deshalb liegt ein vergleichsweise schonender Betrieb vor, im Vergleich beispielsweise zu Automobilanwendung.

Beispielsweise wurden voranstehend verschiedene Techniken im Zusammenhang mit einer Ermittlung eines Zustandswerts einer Batterie beschrieben. Solche Techniken können auch für individuelle Blöcke der Batterie oder Zellen oder Zellgruppen der Batterie implementiert werden. Das bedeutet, dass einzelne Werte oder Größen, wie voranstehenden beschrieben, auch jeweils individuell für einzelne Zellen oder Zellgruppen bestimmt sein können.

Beispielsweise wurden verschiedene Techniken im Zusammenhang mit dem Ermitteln des Zustandswerts der Batterie beschrieben. Diese Techniken wurden in einem Kontext beschrieben, bei dem der Zustandswert in Abhängigkeit vom gegenwärtigen Alterungswert sowie vom zukünftigen Alterungswert ermittelt wird. Dabei wäre es aber im Allgemeinen in einer nicht beanspruchten Ausführungsform denkbar, dass nur einer der beiden Alterungswerte berücksichtigt wird oder aber gänzlich andere Alterungskenngrößen beim Ermitteln des Zustandswerts berücksichtigt werden.

## Patentansprüche

1. Verfahren zum Ermitteln eines Zustandswerts (99) im Zusammenhang mit einer Alterung einer wiederaufladbaren Batterie (91-96), wobei das Verfahren umfasst:
- Ermitteln (1001) eines gegenwärtigen Alterungswerts (98) der Batterie (91-96),
- Erfassen von historischen Belastungsprofilen (500, 700) eines Batterieensembles mit einer Vielzahl von Batterien (91-96) desselben Typs und/oder Batterien (91-96) im selben Anwendungsszenario,
- Bestimmen zumindest eines von mehreren antizipierten Belastungsprofilen (500, 700) der Batterie (91-96) basierend auf den historischen Belastungsprofilen (500, 700) des Batterieensembles,
- Parametrieren eines Alterungsmodells basierend auf kalendarischen und/oder zyklisierten Wertereihen ein oder mehrerer Leistungskenngrößen (511, 512, 513) der Batterien (91-96) des Batterieensembles,
- Ermitteln (1002) mehrerer zukünftiger Alterungswerte (98) der Batterie (91-96) mittels des Alterungsmodells und basierend auf dem gegenwärtigen Alterungswert (98), und
- Ermitteln (1003) des Zustandswerts (99) der Batterie (91-96) basierend auf mehreren Alterungskenngrößen, die zumindest den gegenwärtigen Alterungswert und die mehreren zukünftigen Alterungswerte umfassen,
wobei das Alterungsmodell die mehreren zukünftigen Alterungswerte basierend auf den mehreren antizipierten Belastungsprofilen (500, 700) ermittelt,
wobei die mehreren antizipierten Belastungsprofile mehreren unterschiedlichen Anwendungsszenarien entsprechen,
wobei die mehreren unterschiedlichen Anwendungsszenarien ausgewählt sind aus folgender Gruppe: stationärer Energiespeicher in einem Mikrostromnetz; Energiespeicher für mobile Anwendungen; Niederlastenergiespeicher; Energiespeicher für Leichtelektrofahrzeuge; Energiespeicher für Elektropersonenkraftwagen; Innenraumanwendung; und Außenraumanwendung.

2. Verfahren nach Anspruch 1,
wobei die mehreren zukünftigen Alterungswerte (98) eine kalendarische und/oder zyklisierte Wertereihe ein oder mehrerer Leistungskenngrößen (511, 512, 513) der Batterie (91-96) umfassen,
wobei das Verfahren weiterhin umfasst:
- Bestimmen eines Abstands zu einem Lebensende-Kriterium (189) der Batterie (91-96), basierend auf einer Analyse der Wertereihe zum Erkennen einer Signatur der ein oder mehreren Leistungskenngrößen (511, 512, 513) der Batterie (91-96), die dem Lebensende-Kriterium (189) entspricht,
wobei die mehreren Alterungskenngrößen den Abstand zum Lebensende-Kriterium (189) umfassen.

3. Verfahren nach Anspruch 2,
wobei die Signatur eine sprunghafte Abnahme mindestens einer der ein oder mehreren Leistungskenngrößen (511, 512, 513) der Batterie (91-96) umfasst.

4. Verfahren nach Anspruch 2 oder 3,
wobei die Signatur eine Abnahme oder Überschreitung mindestens einer der ein oder mehreren Leistungskenngrößen (511, 512, 513) der Batterie (91-96) unter oder über einen Schwellenwert (188) umfasst,
wobei das Verfahren weiterhin umfasst:
- Bestimmen des Schwellenwerts (188) in Abhängigkeit von den mehreren antizipierten Belastungsprofilen (500, 700) oder einem antizipierten Anwendungsszenario der Batterie (91-96).

5. Verfahren nach einem der voranstehenden Ansprüche, wobei das Verfahren weiterhin umfasst:
- Erfassen eines historischen Belastungsprofils (500, 700) der Batterie (91-96), und
- Bestimmen eines der mehreren antizipierten Belastungsprofile (500, 700) der Batterie (91-96) basierend auf dem historischen Belastungsprofil (500, 700) der Batterie (91-96),
wobei das Alterungsmodell den entsprechenden zukünftigen Alterungswert basierend auf dem einen der mehreren antizipierten Belastungsprofile (500, 700) vorhersagt.

6. Verfahren nach Anspruch 1, wobei das Verfahren weiterhin umfasst:
- Auswählen von ein oder mehreren zukünftigen Alterungswerten als Alterungskenngrößen für die Ermittlung des Zustandswerts (99) basierend auf einem Vergleich der mehreren zukünftigen Alterungswerte.

7. Verfahren nach Anspruch 1 oder 6, wobei das Verfahren weiterhin umfasst:
- Auswählen eines bestimmten Anwendungsszenarios aus den mehreren Anwendungsszenarien in Abhängigkeit von einem Vergleich der mehreren zukünftigen Alterungswerte.

8. Verfahren nach Anspruch 7, wobei das Verfahren weiterhin umfasst:
- Einbauen der Batterie oder zumindest einer Zelle der Batterie in ein Gerät, das in Abhängigkeit von dem Auswählen des bestimmten Anwendungsszenarios ausgewählt wird, wobei unterschiedliche Anwendungsszenarien mit unterschiedlichen Geräten assoziiert sind.

9. Verfahren nach einem der Ansprüche 1 bis 4, das weiterhin umfasst:
- Erfassen eines historischen Belastungsprofils (500, 700) der Batterie (91-96), wobei die Alterungskenngrößen weiterhin das historische Belastungsprofil (500, 700) der Batterie (91-96) umfassen.

10. Verfahren nach Anspruch 9,
wobei das historische Belastungsprofil (500, 700) der Batterie (91-96) kalendarische und/oder zyklisierte Wertereihen ein oder mehrerer Leistungskenngrößen (511, 512, 513) der Batterien (91-96) umfasst, und/oder
wobei das historische Belastungsprofil (500, 700) der Batterie (91-96) Ereignisse indiziert, bei denen ein oder mehrere Leistungskenngrößen (511, 512, 513) in mindestens einem vorgegebenen Bereich liegen (501), und/oder wobei das historische Belastungsprofil (500, 700) der Batterie (91-96) aggregierte Leistungskenngrößen (511, 512, 513) der Batterie (91-96) umfasst.

11. Verfahren nach einem der voranstehenden Ansprüche,
wobei der Zustandswert basierend auf einer Kombination der mehreren Alterungskenngrößen ermittelt wird,
wobei das Verfahren weiterhin umfasst:
- Bestimmen von Kombinationsgewichten der Kombination basierend auf dem gegenwärtigen Alterungswert und einem der zukünftigen Alterungswerte.

12. Verfahren nach einem der voranstehenden Ansprüche, wobei das Verfahren weiterhin umfasst:
- Vergleichen des Zustandswerts mit einer Vielzahl von Referenz-Zustandswerten von weiteren Batterien (91-96) desselben Typs, und
- Ausgeben einer Warnung in Abhängigkeit von dem Vergleichen.

13. Vorrichtung (81) mit einem Prozessor (51) und einem Speicher (52), wobei der Prozessor eingerichtet ist, um Programmcode aus dem Speicher zu laden und auszuführen, wobei das Ausführen des Programmcodes bewirkt, dass der Prozessor ausführt:
- Ermitteln eines gegenwärtigen Alterungswerts (98) der Batterie (91-96),
- Erfassen von historischen Belastungsprofilen (500, 700) eines Batterieensembles mit einer Vielzahl von Batterien (91-96) desselben Typs und/oder Batterien (91-96) im selben Anwendungsszenario,
- Bestimmen zumindest eines von mehreren antizipierten Belastungsprofilen (500, 700) der Batterie (91-96) basierend auf den historischen Belastungsprofilen (500, 700) des Batterieensembles,
- Parametrieren eines Alterungsmodells basierend auf kalendarischen und/oder zyklisierten Wertereihen ein oder mehrerer Leistungskenngrößen (511, 512, 513) der Batterien (91-96) des Batterieensembles,
- Ermitteln mehrerer zukünftiger Alterungswerte (98) der Batterie (91-96) mittels des Alterungsmodells und basierend auf dem gegenwärtigen Alterungswert, und
- Ermitteln eines Zustandswerts (99) der Batterie (91-96) basierend auf mehreren Alterungskenngrößen, die zumindest den gegenwärtigen Alterungswert und die zukünftigen Alterungswerte umfassen,
wobei das Alterungsmodell die mehreren zukünftigen Alterungswerte basierend auf den mehreren antizipierten Belastungsprofilen (500, 700) ermittelt,
wobei die mehreren antizipierten Belastungsprofile mehreren unterschiedlichen Anwendungsszenarien entsprechen,
wobei die mehreren unterschiedlichen Anwendungsszenarien ausgewählt sind aus folgender Gruppe: stationärer Energiespeicher in einem Mikrostromnetz; Energiespeicher für mobile Anwendungen; Niederlastenergiespeicher; Energiespeicher für Leichtelektrofahrzeuge; Energiespeicher für Elektropersonenkraftwagen; Innenraumanwendung; und Außenraumanwendung.

## Claims

1. Method for obtaining a state value (99) related to the ageing of a rechargeable battery (91-96), the method comprising:
- obtaining (1001) a current ageing value (98) of the battery (91-96),
- acquiring historical load profiles (500, 700) of a battery assembly with a plurality of batteries (91-96) of the same type and/or batteries (91-96) in the same application scenario,
- determining at least one of multiple anticipated load profiles (500, 700) of the battery (91-96) based on the historical load profiles (500, 700) of the battery assembly,
- parameterizing an ageing model based on calendar and/or cycled value series of one or more performance parameters (511, 512, 513) of the batteries (91-96) of the battery assembly,
- obtaining (1002) multiple future ageing values (98) of the battery (91-96) by means of the ageing model and based on the current ageing value (98), and
- obtaining (1003) the state value (99) of the battery (91-96) based on multiple ageing parameters comprising at least the current ageing value and the multiple future ageing values,
wherein the ageing model obtains the multiple future ageing values based on the multiple anticipated load profiles (500, 700),
wherein the multiple anticipated load profiles correspond to multiple different application scenarios,
wherein the multiple different application scenarios are selected from the following group: stationary energy storage in a microgrid; energy storage for mobile applications; low-load energy storage; energy storage for light electric vehicles; energy storage for electric passenger cars; interior application; and exterior application.

2. Method according to claim 1,
wherein the multiple future ageing values (98) comprise a calendar and/or cycled value series of one or more performance parameters (511, 512, 513) of the battery (91-96),
wherein the method further comprises:
- determining a distance to an end-of-life criterion (189) of the battery (91-96) based on an analysis of the value series for detecting a signature of the one or more performance parameters (511, 512, 513) of the battery (91-96) corresponding to the end-of-life criterion (189),
wherein the multiple ageing parameters comprise the distance to the end-of-life criterion (189).

3. Method according to claim 2,
wherein the signature comprises an abrupt decrease in at least one of the one or more performance parameters (511, 512, 513) of the battery (91-96).

4. Method according to claim 2 or 3,
wherein the signature comprises a decrease or excess of at least one of the one or more performance parameters (511, 512, 513) of the battery (91-96) below or above a threshold value (188),
wherein the method further comprises:
- determining the threshold value (188) depending on the multiple anticipated load profiles (500, 700) or an anticipated application scenario of the battery (91-96).

5. Method according to one of the preceding claims, wherein the method further comprises:
- acquiring a historical load profile (500, 700) of the battery (91-96), and
- determining one of the multiple anticipated load profiles (500, 700) of the battery (91-96) based on the historical load profile (500, 700) of the battery (91-96),
wherein the ageing model predicts the corresponding future ageing value based on the one of the multiple anticipated load profiles (500, 700).

6. Method according to claim 1, wherein the method further comprises:
- selecting one or more future ageing values as ageing parameters for obtaining the state value (99) based on a comparison of the multiple future ageing values.

7. Method according to claim 1 or 6, wherein the method further comprises:
- selecting a particular application scenario from the multiple application scenarios depending on a comparison of the multiple future ageing values.

8. Method according to claim 7, wherein the method further comprises:
- installing the battery or at least one cell of the battery into an apparatus selected depending on the selection of the particular application scenario, wherein different application scenarios are associated with different apparatuses.

9. Method according to any one of claims 1 to 4, which further comprises:
- acquiring a historical load profile (500, 700) of the battery (91-96), wherein the ageing parameters further comprise the historical load profile (500, 700) of the battery (91-96).

10. Method according to claim 9,
wherein the historical load profile (500, 700) of the battery (91-96) comprises calendar and/or cycled value series of one or more performance parameters (511, 512, 513) of the batteries (91-96), and/or
wherein the historical load profile (500, 700) of the battery (91-96) indicates events in which one or more performance parameters (511, 512, 513) are within at least a predetermined range (501), and/or wherein the historical load profile (500, 700) of the battery (91-96) comprises aggregated performance parameters (511, 512, 513) of the battery (91-96).

11. Method according to one of the preceding claims,
wherein the state value is obtained based on a combination of the multiple ageing parameters,
wherein the method further comprises:
- determining combination weights of the combination based on the current ageing value and one of the future ageing values.

12. Method according to one of the preceding claims, wherein the method further comprises:
- comparing the state value with a plurality of reference state values of further batteries (91-96) of the same type, and
- issuing a warning depending on the comparison.

13. Device (81) comprising a processor (51) and a memory (52), the processor being configured to load and execute program code from the memory, wherein executing the program code causes the processor to execute:
- Determining a current ageing value (98) of the battery (91-96),
- acquiring historical load profiles (500, 700) of a battery assembly with a plurality of batteries (91-96) of the same type and/or batteries (91-96) in the same application scenario,
- determining at least one of multiple anticipated load profiles (500, 700) of the battery (91-96) based on the historical load profiles (500, 700) of the battery assembly,
- parameterizing an ageing model based on calendar and/or cycled value series of one or more performance parameters (511, 512, 513) of the batteries (91-96) of the battery assembly,
- obtaining multiple future ageing values (98) of the battery (91-96) by means of the ageing model and based on the current ageing value, and
- obtaining a state value (99) of the battery (91-96) based on multiple ageing parameters comprising at least the current ageing value and the future ageing values,
wherein the ageing model obtains the multiple future ageing values based on the multiple anticipated load profiles (500, 700),
wherein the multiple anticipated load profiles correspond to multiple different application scenarios,
wherein the multiple different application scenarios are selected from the following group: stationary energy storage in a microgrid; energy storage for mobile applications; low-load energy storage; energy storage for light electric vehicles; energy storage for electric passenger cars; interior application; and exterior application.

## Revendications

1. Procédé pour obtenir une valeur d'état (99) liée au vieillissement d'une batterie rechargeable (91-96), ledit procédé comprenant :
- obtention (1001) d'une valeur de vieillissement actuelle (98) de la batterie (91-96),
- acquisition de profils de charge historiques (500, 700) d'un ensemble de batteries comprenant une pluralité de batteries (91-96) du même type et/ou de batteries (91-96) dans le même scénario d'application,
- détermination au moins de l'un des plusieurs profils de charge anticipés (500, 700) de la batterie (91-96) sur la base des profils de charge historiques (500, 700) de l'ensemble de batteries,
- paramétrage d'un modèle de vieillissement sur la base de séries de valeurs calendaires et/ou cycliques d'un ou plusieurs paramètres de performance (511, 512, 513) des batteries (91-96) de l'ensemble de batteries,
- obtention (1002) de plusieurs valeurs futures de vieillissement (98) de la batterie (91-96) à l'aide du modèle de vieillissement et sur la base de la valeur de vieillissement actuelle (98), et
- obtention (1003) de la valeur d'état (99) de la batterie (91-96) sur la base de plusieurs paramètres de vieillissement comprenant au moins la valeur de vieillissement actuelle et les plusieurs valeurs de vieillissement futures,
dans lequel le modèle de vieillissement détermine les plusieurs valeurs de vieillissement futures sur la base des plusieurs profils de charge anticipés (500, 700), dans lequel les plusieurs profils de charge anticipés correspondent à plusieurs scénarios d'application différents,
dans lequel les plusieurs scénarios d'application sont sélectionnés dans le groupe suivant : stockage d'énergie stationnaire dans un micro-réseau électrique ; stockage d'énergie pour les applications mobiles ; stockage d'énergie à faible charge ; stockage d'énergie pour les véhicules électriques légers ; stockage d'énergie pour les voitures électriques ; application intérieure ; et application extérieure.

2. Procédé selon la revendication 1,
dans lequel les plusieurs valeurs futures de vieillissement (98) comprennent une série de valeurs calendaires et/ou cycliques d'un ou plusieurs paramètres de performance (511, 512, 513) de la batterie (91-96),
le procédé comprenant en outre :
- détermination d'une distance par rapport à un critère de fin de vie (189) de la batterie (91-96), sur la base d'une analyse de la série de valeurs pour détecter une signature d'un ou plusieurs paramètres de performance (511, 512, 513) de la batterie (91-96) correspondant au critère de fin de vie (189),
dans lequel les plusieurs paramètres de vieillissement comprennent la distance par rapport au critère de fin de vie (189).

3. Procédé selon la revendication 2,
dans lequel la signature comprend une diminution brusque d'au moins un des un ou plusieurs paramètres de performance (511, 512, 513) de la batterie (91-96).

4. Procédé selon la revendication 2 ou 3,
dans lequel la signature comprend une diminution ou un dépassement d'au moins un des un ou plusieurs paramètres de performance (511, 512, 513) de la batterie (91-96) en dessous ou au-dessus d'une valeur de seuil (188),
le procédé comprenant en outre :
- détermination de la valeur de seuil (188) en fonction des plusieurs profils de charge anticipés (500, 700) ou d'un scénario d'application anticipé de la batterie (91-96).

5. Procédé selon l'une quelconque des revendications précédentes, le procédé comprenant en outre :
- acquisition d'un profil de charge historique (500, 700) de la batterie (91-96), et
- détermination de l'un des plusieurs profils de charge anticipés (500, 700) de la batterie (91-96) sur la base du profil de charge historique (500, 700) de la batterie (91-96),
dans lequel le modèle de vieillissement prédit la valeur de vieillissement future correspondante sur la base de l'un des plusieurs profils de charge anticipés (500, 700).

6. Procédé selon la revendication 1, dans lequel le procédé comprend en outre :
- sélection d'une ou de plusieurs valeurs de vieillissement futures comme paramètres de vieillissement pour l'obtention de la valeur d'état (99) sur la base d'une comparaison des plusieurs valeurs de vieillissement futures.

7. Procédé selon la revendication 1 ou 6, dans lequel le procédé comprend en outre :
- sélection d'un scénario d'application spécifique parmi les plusieurs scénarios d'application en fonction d'une comparaison des plusieurs valeurs de vieillissement futures.

8. Procédé selon la revendication 7, dans lequel le procédé comprend en outre :
- installation de la batterie ou au moins d'une cellule de la batterie dans un appareil sélectionné en fonction de la sélection du scénario d'application spécifique, différents scénarios d'application étant associés à différents appareils.

9. Procédé selon l'une quelconque des revendications 1 à 4, comprenant en outre :
- acquisition d'un profil de charge historique (500, 700) de la batterie (91-96), dans lequel les paramètres de vieillissement comprennent en outre le profil de charge historique (500, 700) de la batterie (91-96).

10. Procédé selon la revendication 9,
dans lequel le profil de charge historique (500, 700) de la batterie (91-96) comprend des séries de valeurs calendaires et/ou cycliques d'un ou plusieurs paramètres de performance (511, 512, 513) des batteries (91-96), et/ou
dans lequel le profil de charge historique (500, 700) de la batterie (91-96) indique des événements dans lesquels un ou plusieurs paramètres de performance (511, 512, 513) se trouvent dans au moins une plage prédéterminée (501), et/ou dans lequel le profil de charge historique (500, 700) de la batterie (91-96) comprend des paramètres de performance agrégés (511, 512, 513) de la batterie (91-96).

11. Procédé selon l'une quelconque des revendications précédentes,
dans lequel la valeur d'état est obtenue sur la base d'une combinaison des plusieurs paramètres de vieillissement,
le procédé comprenant en outre :
- détermination des poids de combinaison de la combinaison sur la base de la valeur de vieillissement actuelle et de l'une des valeurs de vieillissement futures.

12. Procédé selon l'une quelconque des revendications précédentes, le procédé comprenant en outre :
- comparaison de la valeur d'état à une pluralité de valeurs d'état de référence d'autres batteries (91-96) du même type, et
- émission d'un avertissement en fonction de la comparaison.

13. Dispositif (81) comprenant un processeur (51) et une mémoire (52), le processeur étant configuré pour charger et exécuter du code de programme à partir de la mémoire, l'exécution du code de programme faisant en sorte que le processeur exécute :
- obtention d'une valeur de vieillissement actuelle (98) de la batterie (91-96),
- acquisition de profils de charge historiques (500, 700) d'un ensemble de batteries comprenant une pluralité de batteries (91-96) du même type et/ou de batteries (91-96) dans le même scénario d'application,
- détermination au moins de l'un des plusieurs profils de charge anticipés (500, 700) de la batterie (91-96) sur la base des profils de charge historiques (500, 700) de l'ensemble de batteries,
- paramétrage d'un modèle de vieillissement sur la base de séries de valeurs calendaires et/ou cycliques d'un ou plusieurs paramètres de performance (511, 512, 513) des batteries (91-96) de l'ensemble de batteries,
- obtention de plusieurs valeurs futures de vieillissement (98) de la batterie (91-96) à l'aide du modèle de vieillissement et sur la base de la valeur de vieillissement actuelle, et
- obtention d'une valeur d'état (99) de la batterie (91-96) sur la base de plusieurs paramètres de vieillissement comprenant au moins la valeur de vieillissement actuelle et les valeurs de vieillissement futures,
dans lequel le modèle de vieillissement détermine les plusieurs valeurs de vieillissement futures sur la base des plusieurs profils de charge anticipés (500, 700), dans lequel les plusieurs profils de charge anticipés correspondent à plusieurs scénarios d'application différents,
dans lequel les plusieurs scénarios d'application sont sélectionnés dans le groupe suivant : stockage d'énergie stationnaire dans un micro-réseau électrique ; stockage d'énergie pour les applications mobiles ; stockage d'énergie à faible charge ; stockage d'énergie pour les véhicules électriques légers ; stockage d'énergie pour les voitures électriques ; application intérieure ; et application extérieure.
